# EUROPEAN PATENT SPECIFICATION

(11) **EP 1 921 905 B1**
(45) Date of publication and mention of the grant of the patent: **05.08.2009**
(21) Application number: 06742180.0
(22) Date of filing: 16.06.2006
(51) Int. Cl.: H05K 7/14, H05K 9/00, H04Q 1/10

(54) **SHIELDING PINBOARD MODULE**
ABSCHIRMENDES PINBOARD-MODUL
MODULE PANNEAU DE CONNEXION À BROCHES POUR BLINDAGE

(30) Priority: 31.08.2005 CN 200520106557 U
(43) Date of publication of application: 14.05.2008
(73) Proprietor: Huawei Technologies Co., Ltd., Shenzhen, Guangdong Province 518129 (CN)
(72) Inventor: YU, Pingfang, 518129 Shenzhen, Guangdong Province (CN)
(74) Representative: Epping - Hermann - Fischer
(86) International application number: PCT/CN2006/001353
(87) International publication number: WO 2007/025430

(56) References cited:
- CN-A- 1 189 085
- CN-Y- 2 523 118
- CN-Y- 2 718 736
- JP-A- 9 006 468

## Description

### TECHNICAL FIELD

The present invention relates to a communication product, especially a shielding subrack module.

### BACKGROUD OF THE INVENTION

Electromagnetic compatibility (EMC) Compulsory Certification relating to electronic products is one of fundamental requirements for market admittance. European Union and developed countries in North America and so on enact laws and regulations relating to EMC and implement EMC Compulsory Certification. In China EMC Compulsory Certification, such as 3C Compulsory Certification, also begins to apply to some products. In addition, EMC properties of products have close relations with operating reliability of products, in other words, ensuring EMC properties of products can improve environmental adaptability of products. Therefore, EMC properties of products, which are one of the essential technical indexes of products, have been paid more and more attention all around the world. For attaining EMC properties of products, measures in terms of shielding, grounding, filtering, cabling etc. need to be made when designing EMC. However, if the measures taken are inappropriate, it will greatly increase the cost of electronic products, which in turn decreases the profitability of products, or even causes to lose money in business. Thus it is important to lower the cost of EMC design of products. Currently, circuit board type shielding subrack of electronic products in the prior arts typically utilizes the following technical solutions to attain shielding.

### The first prior art

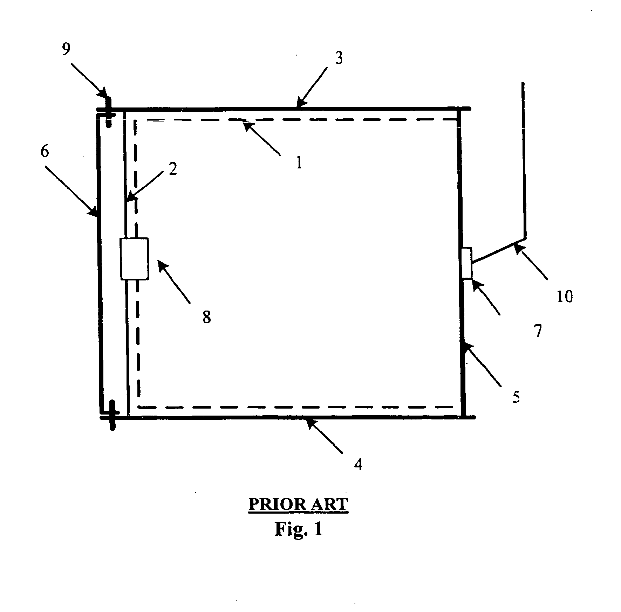

Figure 1 is a structural schematic sectional view of a shielding subrack for installing a circuit board 1 in the first prior art. Each of the six sides of the subrack is formed of sheet material with shielding layer, typically metal plate. The gaps between the upper cover plate 3 and the left, right side plates (not shown in figures) as well as between the lower cover plate 4 and the left, right side plates are fixed by screws or rivets 9 with each other. The distance between the screws or rivets 9 is required to meet the shielding requirements and is typically 20-60 mm. Shielding materials are arranged in the active gaps between the front panel 5, the rear cover plate 6 and the other plates. In such a way, the six metal sides of the subrack form a shielding chamber, and the external-interfacing signal line 10 of the circuit board is generally led out from the connector 7 arranged on the front panel.

Because each of the six sides of the subrack is a metal plate and the shielding materials are arranged in the active gaps of the front panel and the rear cover plate, the shielding cost is high. In addition, the rear shielding cover plate occupies a certain space, in the case that the depth dimension of the subrack is limited, the effective depth dimension provided for the circuit board within the subrack will be reduced, which configuration is adverse to the installation of boards carrying traffic with high density.

### The second prior art

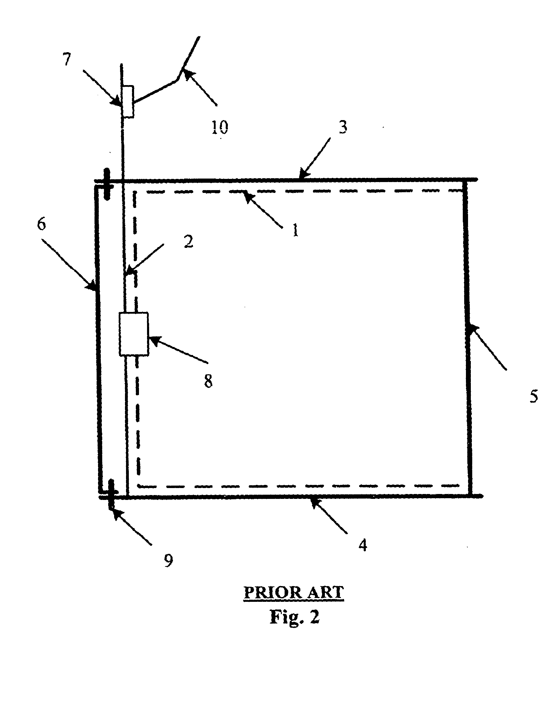

Figure 2 is a structural schematic sectional view of a shielding subrack for installing a circuit board 1 in the second prior art. Each of the six sides of the subrack is formed of sheet material with shielding layer, typically a metal plate. The gaps between the upper cover plate 3 and the left, right side plates (not shown in figures) as well as between the lower cover plate 4 and the left, right side plates are fixed by screws or rivets 9 with each other. The distance between the screws or rivets 9 is required to meet the shielding requirements and is typically 20-60 mm. Shielding materials are arranged in the active gaps between the front panel 5, the rear cover plate 6 and the other plates. The backplane 2 is firstly installed in the back of the subrack. The backplane 2 is a printed circuit board and extends upward beyond the subrack. The rear shielding cover plate 6 then is installed behind the backplane 2. The rear shielding cover plate 6 is connected with the subrack at the periphery thereof by screws 9 to keep electromagnetic sealing. The external-interfacing signal line 10 runs inside the backplane and goes to the output-line area above the backplane, then is led out via the connector 7 in the output-line area.

Because each of the six sides of the subrack is a metal plate and shielding material are arranged in the active gaps of the front panel and the rear cover plate, the shielding cost is high. In addition, a great number of signal lines need to be connected via the backplane, as a result, the number of the backplane's layers increases, and thus the cost of the backplane, are largely increased. Moreover, the signal lines being connected via the backplane results in an increased height of the whole subrack, which in turn causes the number of subracks installed in the equipment cabinet to be reduced, thereby decreasing the total working capacity and also increasing the costs indirectly.

Another Prior Art example is JP-A-09 006468 (TOSHIBA KK) to take, which discloses a circuit substrate rack having ground layer provided at backplane.

### SUMMARY OF THE INVENTION

The present invention discloses a shielding subrack module to solve the problems of high cost and large volume existed in the shielding subrack of the prior arts.

### Disclosed herein is a shielding subrack module

comprising: a subrack body having an upper cover plate, a lower cover plate, a front panel, a left side plate and a right side plate; and a backplane whose edges fixedly connected to the peripheral hem of the subrack body, the backplane being a printed circuit board, wherein both surfaces of the backplane are covered by shielding copper sheet with no traces, and each of the upper cover plate, the lower cover plate, the front panel, the left side plate and the right side plate includes a shielding layer.

The backplane has an insulating layer coated on the surfaces of the shielding copper sheets.

The insulating layer is coated on the surfaces other than joining surface of the shielding copper sheet of the backplane with the peripheral hem of the subrack body.

The upper cover plate, the lower cover plate, the front panel, the left side plate and the right side plate are respectively fixedly connected by screws or rivets.

The backplane and the peripheral hem of the subrack body are fixedly connected each other by screws or rivets.

The distance between the screws or the rivets ranges from 20 to 60 mm.

Shielding materials are arranged in the gaps between the front panel and the upper cover plate, the lower cover plate, the left side plate and the right side plate.

The subrack module further comprises a circuit board installed in the subrack body, and the circuit board is electrically connected to the backplane by a first connector arranged on the backplane.

The circuit board is further electrically connected to an external-interfacing signal line by the first connector. Or the subrack module further comprises a second connector arranged on the front panel; and the circuit board is electrically connected to the external-interfacing signal line by the second connector.

The present invention has the following advantages:
1. Shielding is achieved directly by a single backplane which is a printed circuit board whose both sides are covered by copper and a rear cover plate is omitted, thereby lowering shielding cost;
2. No installing position for the rear cover plate is need, so that effective size of the circuit board can be expanded, which facilitates the installation of the boards carrying traffic with high density;
3. The number of components of the whole subrack is reduced, so that the structure of the subrack becomes more compact, the installing procedures thereof are simplified, and the production efficiency is improved;
4. The external-connecting manner of the signal line is so flexible that the present invention is suitable for various applications.

### BRIEF DESCRIPTION OF THE DRAWINGS

Figure 1 is a structural schematic sectional view of a subrack in the first prior art;
Figure 2 is a structural schematic sectional view of a subrack in the second prior art;
Figure 3 is a structural schematic sectional view of a shielding subrack in accordance with the first embodiment of the present invention, wherein a circuit board 1 is electrically connected to an external-interfacing signal line through a connector connecting the circuit board 1 with the backplane 2; and
Figure 4 is a structural schematic sectional view of a shielding subrack in accordance with the second embodiment of the present invention, wherein a circuit board 1 is electrically connected to an external-interfacing signal line through a connector 7 arranged on the front panel 5.

### DETAILED DESCRIPTION OF THE PREFERRED EMBODIMENTS

In view of the disadvantages of high structural cost and large volume existed in the shielding subrack of the prior arts, the object of the invention is to provide a simplified subrack shielding design which lowers the shielding cost and reduces the volume of the subrack.

The technical concept of the present invention lies in that a backplane which is a printed circuit board whose surface/surfaces is/are covered by non-wiring copper sheets is utilized to directly function as a shield body and the rear cover plate is omitted, which in one respect lowers the shielding cost, and in the other respect, reduces the volume of the subrack and saves valuable space in the electronic products. Now the present invention will be explained in detail by way of exemplary embodiments with reference to the drawings.

### The first embodiment

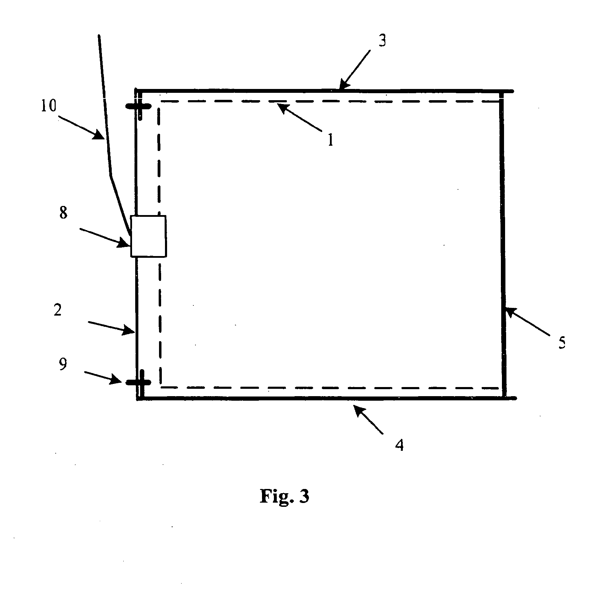

Figure 3 is a structural schematic sectional view of the shielding subrack in accordance with the present invention. The shielding subrack includes a backplane 2 of the circuit board 1, an upper cover plate 3, a lower cover plate 4, left and right side plates (not shown in Figure 3), and a front panel 5. The backplane 2 is a printed circuit board, while the other plates are made of sheet material with a shielding layer, typically a metal plate. The gaps between the upper and lower cover plates as well as the left, right side plates are fixed by screws or rivet with each other. Shielding materials are arranged in the active gaps between the front panel 5 and the upper cover plate 3, the lower cover plate 4, the left, right side plates (not shown in Figure 3).

Only the backplane 2 of the circuit board 1, without another metal rear cover plate, is installed on the back of the subrack. The backplane 2 acts directly as a shielding body. The EMC design requirements of the backplane 2 are as follows: the backplane is a printed circuit board, and both of surface layer and bottom layer are completely covered by copper and have no traces, so as to form a shielding copper sheet; among the surfaces of the shielding copper sheet, except that the joining surface of the peripheral surface layer of the backplane with the subrack is bare copper, the remaining surface can be coated with an insulating layer. The bare copper is provided to achieve an effective electrical connection between the backplane 2 and the peripheral hem of the subrack, to minimize the gap therebetween, and to improve the effect of the electromagnetic shielding.

Screw holes are arranged in the upper, lower, left and right peripheral edges of the backplane 2, and the distance between the screw holes ranges from 20 to 60 mm. When being installed, the peripheral edges of the backplane 2 are connected with the peripheral hem of the subrack by screws to attain joint electromagnetic sealing between the backplane 2 and the subrack. The distance between screws or rivets 9 meets the shielding requirement and is typically 20-60 mm. Thus five metal plates of the subrack together with the backplane 2 form a shielding cavity, satisfying the EMC property requirements of the electronic products.

In the present embodiment, an.external-interfacing signal line of the subrack is led out from the backside of the backplane 2. The circuit board 1 is electrically connected with the external-interfacing signal line 10 through a connector 8 between the circuit board 1 and the backplane 2.

### The second embodiment

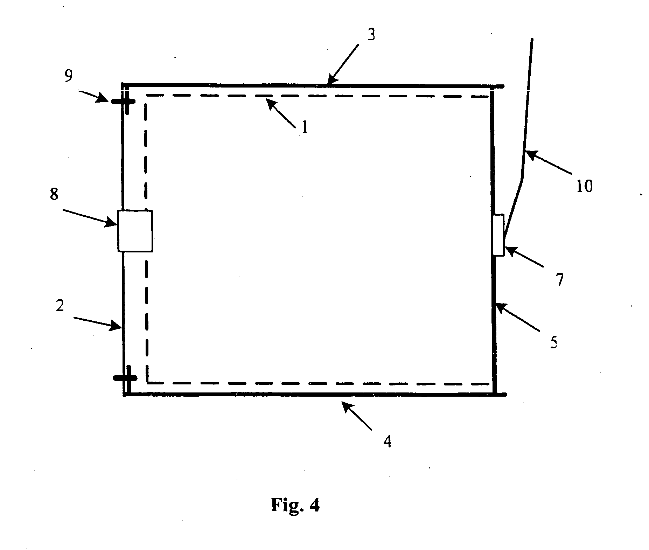

As shown in figure 4, the second embodiment is similar to the first one. For example, the shielding subrack includes a backplane 2 of the circuit board 1, an upper cover plate 3, a lower cover plate 4, left and right side plates (not shown in Figure 4), and a front panel 5, wherein the backplane 2 is a printed circuit board, while the other plates are made of sheet material with a shielding layer, typically a metal plate. The gaps between the upper, lower cover plates as well as the left and right side plates are fixed by screws or rivets with each other. Shielding materials are arranged in the active gaps between the front panel 5 and the upper cover plate 3, the lower cover plate 4, the left and right side plates (not shown in Figure 4).

Only the backplane 2 of the circuit board 1, without another metal rear cover plate, is installed on the back of the subrack. The backplane 2 acts directly as a shielding body. The EMC design requirements of the backplane 2 are as follows: the backplane is a printed circuit board, and both of surface layer and bottom layer are completely covered by copper and have no traces so as to form a shielding copper sheet; among the surfaces of the shielding copper sheet, except that the joining surface of the peripheral surface layer of the backplane with the subrack is bare copper, the remaining surface can be coated with an insulating layer. The bare copper is provided to achieve an effective electrical connection between the backplane 2 and the peripheral hem of the subrack, to minimize the gap therebetween, and to improve the effect of the electromagnetic shielding.

Screw holes are arranged in the upper, lower, left and right peripheral edges of the backplane 2, and the distance between the screw holes ranges from 20 to 60 mm. When being installed, the peripheral edges of the backplane 2 are connected with the peripheral hem of the subrack by screws to attain joint electromagnetic sealing between the backplane and the subrack. The distance between screws or rivets 9 meets the shielding requirement and is typically 20-60 mm. Thus five metal plates of the subrack together with the backplane 2 form a shielding cavity, satisfying the EMC property requirements of the electronic products.

In the second embodiment, unlike the first one, the external-interfacing signal line 10 is led out from the front of the subrack. The circuit board 1 is electrically connected with the external-interfacing signal line 10 through a connector 7 arranged on the front panel 5.

It is apparent to those skilled in the art that various changes and modifications may be made without departing from the spirit and scope of the invention as defined by the appended claims. Thus, it is intended to include the various changes and modifications fall within the scope of the appended claims and the equivalents thereof.

## Claims

1. A shielding subrack module, comprising:
a subrack body comprising an upper cover plate (3), a lower cover plate (4), a front panel (5), a left side plate and a right side plate; and
a backplane (2) whose edges fixedly connected to the peripheral hem of the subrack body, and the backplane (2) being a printed circuit board,
**characterized in that**, both surfaces of the backplane (2) are covered by shielding copper sheet with no traces, and each of the upper cover plate (3), the lower cover plate (4), the front panel (5), the left side plate and the right side plate includes a shielding layer.

2. The shielding subrack module according to claim 1, **characterized in that**, an insulating layer is coated on the surface of the shielding copper sheet.

3. The shielding subrack module according to claim 2, **characterized in that**, the insulating layer is coated on the surfaces other than the joining surface of the shielding copper sheet of the backplane (2) with the peripheral hem of the subrack body.

4. The shielding subrack module according to claim 1, 2 or 3, **characterized in that,** the upper cover plate (3), the lower cover plate (4), the front panel (5), the left side plate and the right side plate are respectively fixedly connected by screws or rivets (9).

5. The shielding subrack module according to claim 4, **characterized in that,** the backplane (2) and the peripheral hem of the subrack body are fixedly connected each other by screws or rivets (9).

6. The shielding subrack module according to claim 5, **characterized in that,** the distance between the screws or the rivets (9) ranges from 20 to 60 mm.

7. The shielding subrack module according to claim 1, **characterized in that,** shielding materials are arranged in gaps between the front panel (5) and, the upper cover plate (3), the lower cover plate (4), the left side plate and the right side plate.

8. The shielding subrack module according to claim 1, 2, or 3, **characterized in that,** the subrack module further comprises a circuit board (1) installed in the subrack body, and the circuit board (1) is electrically connected to the backplane (2) by a first connector (8) arranged on the backplane (2).

9. The shielding subrack module according to claim 8, **characterized in that,** the circuit board (1) is further electrically connected to an external-interfacing signal line (10) by the first connector (8).

10. The shielding subrack module according to claim 8, **characterized in that,** the subrack module further comprises a second connector (7) arranged on the front panel (5), and the circuit board (1) is electrically connected to the external-interfacing signal line (10) by the second connector (7).

## Patentansprüche

1. Abschirmendes Baugruppenträger-Modul, umfassend:
einen Grundkörper des Baugruppenträgers, welcher umfasst eine obere Deckplatte (3), eine untere Deckplatte (4), ein Frontpaneel (5), eine linke Platte und eine rechte Platte, und eine Rückwandplatine (2), deren Kanten fest mit der Randumfassung des Grundkörpers des Baugruppenträgers verbunden sind und wobei die Rückwandplatine (2) eine Leiterplatte ist,
**dadurch gekennzeichnet, dass** beide Oberflächen der Rückwandplatine (2) durch abschirmendes Kupferblech ohne Leiterbahnen bedeckt sind und die obere Deckplatte (3), die untere Deckplatte (4), das Frontpaneel (5), die linke Platte und die rechte Platte jeweils eine Abschirmungsschicht umfassen.

2. Abschirmendes Baugruppenträger-Modul nach Anspruch 1, **dadurch gekennzeichnet, dass** eine Isolierschicht auf der Oberfläche des abschirmenden Kupferblechs aufgebracht ist.

3. Abschirmendes Baugruppenträger-Modul nach Anspruch 2, **dadurch gekennzeichnet, dass** die Isolierschicht auf der anderen Oberfläche als der Verbindungsoberfläche des abschirmenden Kupferblechs der Rückwandplatine (2) zu der Randumfassung des Grundkörpers des Baugruppenträgers aufgebracht ist.

4. Abschirmendes Baugruppenträger-Modul nach Anspruch 1, 2 oder 3, **dadurch gekennzeichnet, dass** die obere Deckplatte (3), die untere Deckplatte (4), das Frontpaneel (5), die linke Platte und die rechte Platte jeweils durch Schrauben oder Nieten (9) fest verbunden sind.

5. Abschirmendes Baugruppenträger-Modul nach Anspruch 4, **dadurch gekennzeichnet, dass** die Rückwandplatine (2) und die Randumfassung des Grundkörpers des Baugruppenträgers durch Schrauben oder Nieten (9) fest miteinander verbunden sind.

6. Abschirmendes Baugruppenträger-Modul nach Anspruch 5, **dadurch gekennzeichnet, dass** sich die Entfernung zwischen den Schrauben bzw. den Nieten (9) in einem Bereich von 20 bis 60 mm befindet.

7. Abschirmendes Baugruppenträger-Modul nach Anspruch 1, **dadurch gekennzeichnet, dass** Abschirmungsmaterialien in Spalten zwischen dem Frontpaneel (5) und der oberen Deckplatte (3), der unteren Deckplatte (4), der linken Seitenplatte und der rechten Seitenplatte angeordnet sind.

8. Abschirmendes Baugruppenträger-Modul nach Anspruch 1, 2 oder 3, **dadurch gekennzeichnet, dass** das Baugruppenträger-Modul ferner eine Leiterplatte (1) umfasst, welche in dem Grundkörper des Baugruppenträgers installiert ist, und die Leiterplatte (1) durch einen ersten Verbinder (8), welcher an der Rückwandplatine (2) angeordnet ist, elektrisch mit der Rückwandplatine (2) verbunden ist.

9. Abschirmendes Baugruppenträger-Modul nach Anspruch 8, **dadurch gekennzeichnet, dass** die Leiterplatte (1) durch den ersten Verbinder (8) ferner elektrisch mit einer Signalleitung (10) zur externen Verbindung verbunden ist.

10. Abschirmendes Baugruppenträger-Modul nach Anspruch 8, **dadurch gekennzeichnet, dass** das Baugruppenträger-Modul ferner einen zweiten Verbinder (7) umfasst, welcher an dem Frontpaneel (5) angeordnet ist, und die Leiterplatte (1) durch den zweiten Verbinder (7) elektrisch mit der Signalleitung (10) zur externen Verbindung verbunden ist.

## Revendications

1. Module de casier de blindage, comprenant :
un corps de casier comprenant une plaque de recouvrement supérieure (3), une plaque de recouvrement inférieure (4), un panneau frontal (5), une plaque latérale gauche et une plaque latérale droite et
un panneau de fond de casier (2) dont les arêtes sont rigidement connectées au bord périphérique du corps de casier, ledit panneau de fond de casier (2) étant une carte de circuit imprimé,
**caractérisé en ce que** les deux surfaces du panneau de fond de casier (2) sont recouvertes d'une feuille de blindage en cuivre sans traces et que la plaque de recouvrement supérieure (3), la plaque de recouvrement inférieure (4), le panneau frontal (5), la plaque latérale gauche et la plaque latérale droite comportent une couche de blindage.

2. Module de casier de blindage selon la revendication 1, **caractérisé en ce qu'**une couche d'isolation est appliquée sur la surface de la feuille de blindage en cuivre.

3. Module de casier de blindage selon la revendication 2, **caractérisé en ce que** la couche d'isolation est appliquée sur la surface de la feuille de blindage en cuivre autre que la surface de jointure de la feuille de blindage en cuivre du panneau de fond de casier (2) avec le bord périphérique du corps de casier.

4. Module de casier de blindage selon l'une quelconque des revendications 1, 2 ou 3, **caractérisé en ce que** la plaque de recouvrement supérieure (3), la plaque de recouvrement inférieure (4), le panneau frontal (5), la plaque latérale gauche et la plaque latérale droite sont respectivement connectés rigidement au moyen de vis ou de rivets (9).

5. Module de casier de blindage selon la revendication 4, **caractérisé en ce que** le panneau de fond de casier (2) et le bord périphérique du corps de casier sont rigidement connectés l'un à l'autre par des vis ou des rivets (9).

6. Module de casier de blindage selon la revendication 5, **caractérisé en ce que** la distance entre les vis ou les rivets (9) est comprise entre 20 et 60 mm.

7. Module de casier de blindage selon la revendication 1, **caractérisé en ce que** des matières de blindage sont disposées dans les intervalles entre le panneau frontal (5) et la plaque de recouvrement supérieure (3), la plaque de recouvrement inférieure (4), la plaque latérale gauche et la plaque latérale droite.

8. Module de casier de blindage selon l'une quelconque des revendications 1, 2, ou 3, **caractérisé en ce que** le module de casier comprend en outre une carte de circuit imprimé (1) logée dans le corps de casier et que ladite carte de circuit imprimé (1) est électriquement connectée au panneau de fond de casier (2) par un premier connecteur (8) disposé sur ledit panneau de fond de casier (2).

9. Module de casier de blindage selon la revendication 8, **caractérisé en ce que** la carte de circuit imprimé (1) est en outre connectée électriquement à une ligne de signaux d'interfaçage externe (10) via le premier connecteur (8).

10. Module de casier de blindage selon la revendication 8, **caractérisé en ce que** le module de casier comporte en outre un second connecteur (7) disposé sur le panneau frontal (5) et que la carte de circuit imprimé (1) est électriquement connectée à la ligne de signaux d'interfaçage externe (10) via ledit second connecteur (7).
